# EUROPEAN PATENT APPLICATION

(11) **EP 2 108 966 A1**
(43) Date of publication of application: **14.10.2009**
(21) Application number: 08103446.4
(22) Date of filing: 08.04.2008
(51) Int. Cl.: G01R 15/18

(54) **Current sensor and assembly group for current measurement**

(71) Applicant: Ecole Polytechnique Fédérale de Lausanne (EPFL), 1015 Lausanne (CH)
(72) Inventor: Popovic, Radivoje, 1025, St-Sulpice (CH); Banjevic, Mirjana, 1004 Lausanne (CH); Dimitopoulos,Panos M., 14564 Kifissia, Athens (GR)
(74) Representative: Falk, Urs

(57) **Abstract**

A current sensor for measuring a primary current flowing through a conductor comprises a coil (2) and electronic circuitry for making a secondary current flow through the coil (2) and a magnetic field sensor. The primary current produces a primary magnetic field and the secondary current produces a secondary magnetic field which point in different directions and add up to a total magnetic field. The magnetic field sensor may be a two-axes magnetic field sensor (4) providing a first output signal that is proportional to a first component of the total magnetic field and a second output signal that is proportional to a second component of the total magnetic field wherein the first and second component of the total magnetic field point in different directions. The coil (2) and the two-axes magnetic field sensor (4) are oriented with respect to each other such that the second output signal is proportional to the secondary magnetic field. The magnetic field sensor may also be an angle sensor (12) providing an output signal proportional to the total magnetic field.

## Description

### FIELD OF THE INVENTION

The invention concerns a current sensor and an assembly group for current measurement.

### BACKGROUND OF THE INVENTION

The measurement principle of the present invention is based on the one hand on the measurement of a magnetic field produced by the current to be measured which is called the primary current and on the other hand on the measurement of an auxiliary magnetic field produced by a secondary current flowing through a coil. The current sensor therefore comprises a magnetic field sensor, such as e.g. a Hall device, a fluxgate sensor or a magnetoresistive sensor like an AMR or GMR sensor. The magnetic field produced by the current to be measured and the auxiliary magnetic field produced by the secondary current flowing through the coil run in the same direction and the magnetic sensor is a single axis sensor the sensitive axis of which is collinear with this direction. The prior art distinguishes mainly between two different implementations of this measurement principle. With the first implementation which is called open-loop type, the auxiliary magnetic field is used to calibrate the magnetic field sensor. The drawback of this implementation is that the value of the auxiliary magnetic field is low, that the auxiliary magnetic field runs in the same direction as the primary current's magnetic field, which makes it difficult to selectively measure it in a signal comprising both the primary current's magnetic field and the auxiliary magnetic field. With the second implementation which is called closed-loop type the auxiliary magnetic field is used to compensate the magnetic field produced by the current to be measured. An advantage of this second implementation is that the output signal of the current sensor does not depend on the characteristics of the magnetic field sensor but the drawback is that the auxiliary magnetic field must be of equal size as the magnetic field produced by the primary current.

### DISCLOSURE OF THE INVENTION

The object of the invention is to develop a current sensor without the above named drawbacks.

The invention is characterized by the independent claim 1. Advantageous embodiments are described in the dependent claims.

In the following, the terms "primary current" and "primary magnetic field" are used to designate the magnetic field produced by the current to be measured, and the terms "secondary current" and "secondary magnetic field" are used to designate the auxiliary magnetic field and the current running through a coil to produce the auxiliary magnetic field. The primary magnetic field and the secondary magnetic field add up to a total magnetic field. The present invention proposes to align the secondary magnetic field with a different direction, preferably perpendicularly, to the primary magnetic field and to use a two-axes magnetic field sensor or a magnetic angle sensor wherein the two-axes sensor measures a first component of the total magnetic field which component runs in the direction of the primary magnetic field and a second component of the total magnetic field which component runs in the direction of the secondary magnetic field or wherein the magnetic angle sensor measures the angle which the total magnetic field includes with a predetermined direction. The two-axes sensor therefore delivers two output signals whereas the angle sensor delivers one output signal. The current sensor further comprises electronic circuitry for the operation of the magnetic field sensor, preferably for the operation in the so-called open-loop or closed-loop mode.

### BRIEF DESCRIPTION OF THE DRAWINGS

The accompanying drawings, which are incorporated into and constitute a part of this specification, illustrate one or more embodiments of the present invention and, together with the detailed description, serve to explain the principles and implementations of the invention. The figures are not to scale. In the drawings:
- Fig. 1: shows a block diagram of a current sensor according to a first embodiment of the invention,
- Fig. 2: shows a block diagram of a current sensor according to a second embodiment of the invention,
- Fig. 3: shows a block diagram of a current sensor according to a third embodiment of the invention,
- Fig. 4: shows a practical application of the current sensor,
- Fig. 5: shows a sensing structure that can be operated as a moving Hall element, and
- Figs. 6 and 7: show embodiments of the current sensor having a sensing structure as shown in Fig. 5.

### DETAILED DESCRIPTION OF THE INVENTION

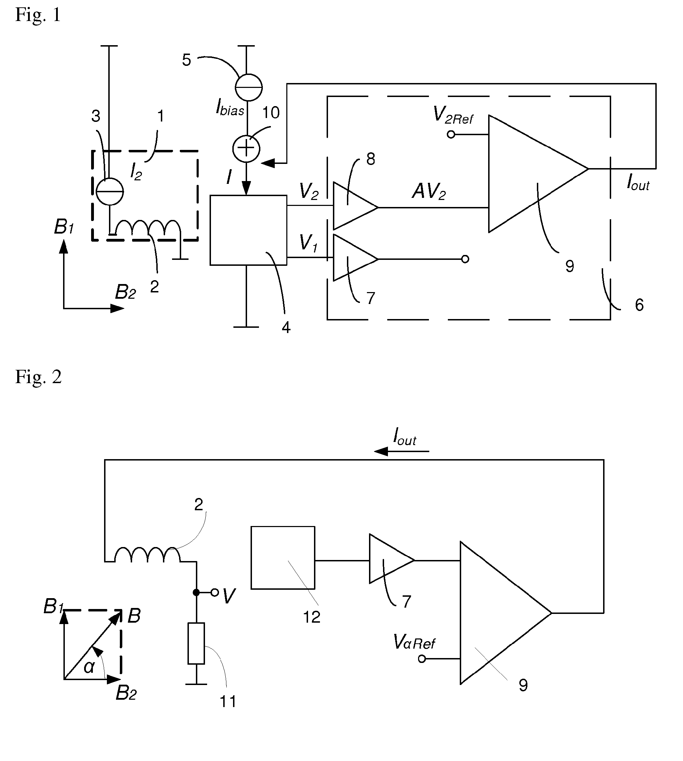

Fig. 1 shows the block diagram of a current sensor according to a first embodiment of the invention in which the current sensor is operated in the open-loop mode. The current sensor comprises a circuit 1 for producing an auxiliary magnetic field B₂ that includes a predefined angle ϕ with the magnetic field B produced by the current to be measured which is denoted as the primary current. The predefined angle ϕ preferably amounts to 90°. The magnetic field B₁ is the primary magnetic field, the magnetic field B₂ is the secondary magnetic field. The circuit 1 comprises a coil 2 and a constant current source 3 arranged in series. The constant current source 3 produces the so called secondary current I₂ that flows through the coil 2 and produces the secondary magnetic field B₂. The primary and secondary magnetic fields B and B₂ lie in the plane of the drawing and their direction is shown by arrows. The current sensor further comprises a two-axes magnetic field sensor 4 that is driven by a current I and delivers two output signals V₁ and V₂, the first output signal V₁ being proportional to the primary magnetic field B and the second output signal V₂ being proportional to the secondary magnetic field B₂. The current sensor further comprises a second current source 5 delivering a constant biasing current I_{bias} and a feedback circuitry 6 for operating the current sensor in the open-loop mode. In this embodiment, the circuitry 6 comprises two pre-amplifiers 7 and 8 for the amplification of the output signals V₁ and V₂ and a feedback loop comprising a comparator 9 having a first and a second input and delivering an output current Iₒᵤₜ. The sensitivity of the two-axes magnetic field sensor 4 is the same for both its measurement directions and the gain A of the two pre-amplifiers 7 and 8 is either the same or has a constant ratio. The output signal V₂ of the magnetic field sensor 4 is fed to the first pre-amplifier 7 and the output signal of the first pre-amplifier 7 AV₂ is fed to the first input of the comparator 9. A constant voltage V_{2Ref} is fed to the second input of the comparator 9. The output current Iₒᵤₜ of the comparator 9 is fed to a summing junction 10 that adds the output current Iₒᵤₜ to the biasing current I_{bias} so that the total current I = I_{bias} + Iₒᵤₜ is fed to the magnetic field sensor 4. The comparator 9 may include a PID regulator as well as a further circuitry needed for the disclosed operation, like e.g. an output stage capable of delivering the necessary output current Iₒᵤₜ.

In this open-loop mode, the circuit 1 produces a constant magnetic reference field, namely the secondary magnetic field B₂ and the circuitry 6 adjusts the output current Iₒᵤₜ of the comparator 9 such that the output signal of the first pre-amplifier 7 achieves the constant value V_{2Ref}, independently from variations of any parameters like actual temperature, actual stress, and so on, at least as long as the secondary current and the reference voltage V_{2Ref} remain constant. The advantage of this embodiment is that the primary and secondary magnetic fields B₁ and B₂ are processed completely independent from each other. In this open loop-mode the current sensor is calibrated permanently and simultaneously with the measurements.

Fig. 2 shows the block diagram of a current sensor according to a second embodiment of the invention in which the current sensor is operated in the closed-loop mode. The current sensor comprises a coil 2 and a resistor 11 arranged in series, a magnetic angle sensor 12 and a comparator 9 having a first input and a second input. The output signal of the magnetic angle sensor 12 is amplified with a pre-amplifier 7 and fed to the first input of the comparator 9 and a constant reference voltage V_{αRef} is applied to the second input of the comparator 9. The comparator 9 delivers an output current Iₒᵤₜ that flows through the coil 2 and the resistor 11. The comparator 9 adjusts the output current Iₒᵤₜ such that the output signal of the magnetic angle sensor 12 remains at a constant value which is equal to the reference voltage V_{αRef}. This means in other words that the comparator 9 regulates the output current Iₒᵤₜ flowing through the coil 2 such that the angle of the total magnetic field B, i.e. the sum of the primary magnetic field B and the secondary magnetic field B₂, adopts a constant value. The output signal of the current sensor is either the current Iₒᵤₜ or the voltage V present at the node between the coil 2 and the resistor 11 which corresponds to the voltage drop on the resistor 11. If the output signal of the angle sensor 12 is a digital signal, the pre-amplifier 7 can be omitted.

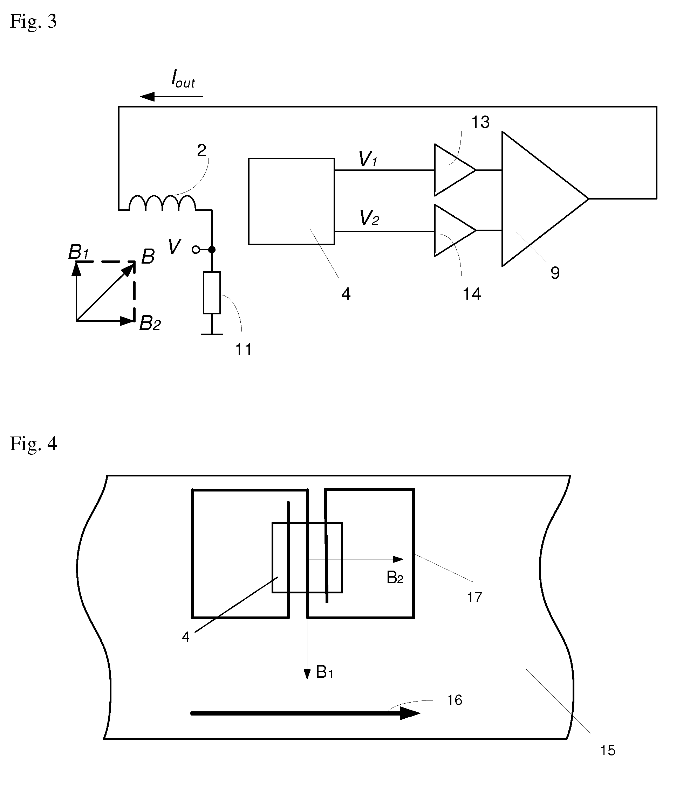

Fig. 3 shows the block diagram of a current sensor according to a third embodiment of the invention. This embodiment is similar to the previous embodiment, but the magnetic angle sensor has been replaced by a two-axes magnetic field sensor 4 that delivers a first output signal V₁ being proportional to the primary magnetic field B and a second output signal V₂ being proportional to the secondary magnetic field B₂. The first output signal V₁ is amplified by a first amplifier 13 and fed to the first input of the comparator 9, the second output signal V₂ is amplified by a second amplifier 14 and fed to the second input of the comparator 9. The gain of the first amplifier 13 may be equal to the gain of the second amplifier 14 which means that the output current Iₒᵤₜ of the comparator 9 produces the secondary magnetic field B₂ that is equal in size as the primary magnetic field B₁. However, it is preferred to have the gain of the second amplifier 14 n times bigger than the gain of the first amplifier 13, wherein the number n can be any suitable number bigger than 1. The number n may for example adopt the value 3 or the value 10 or any other suitable value. The advantage of n > 1 is that the magnitude of the secondary magnetic field B₂ is n times smaller than the magnitude of the primary magnetic field B which allows to reduce the size of the coil 2 and keep the coil 2 comparatively small.

Fig. 4 shows a plan view of a practical implementation and application of the current sensor. The current sensor is located on a flat electrical conductor 15 through which the current to be measured, i.e. the primary current, flows. The primary current flows along the conductor 15 in a direction designated by an arrow 16 and produces the primary magnetic field B₁. The magnetic field sensor 4 is integrated in a semiconductor chip that is located in a conventional manner above the conductor 15. The coil 2 for producing the secondary magnetic field B₂ is a flat coil consisting of conventional conductor tracks 17 formed on the semiconductor chip. The windings of the conductor tracks 17 are oriented so that the secondary magnetic field B₂ points in a direction that is different from the direction of the primary magnetic field B₁. The primary magnetic field B and the secondary magnetic field B₂ include a fixed angle ϕ that is different from ϕ = 0. Preferably, the angle ϕ amounts to ϕ = 90° as shown in this example. The conductor 15 and the current sensor form an assembly group for current measurement.

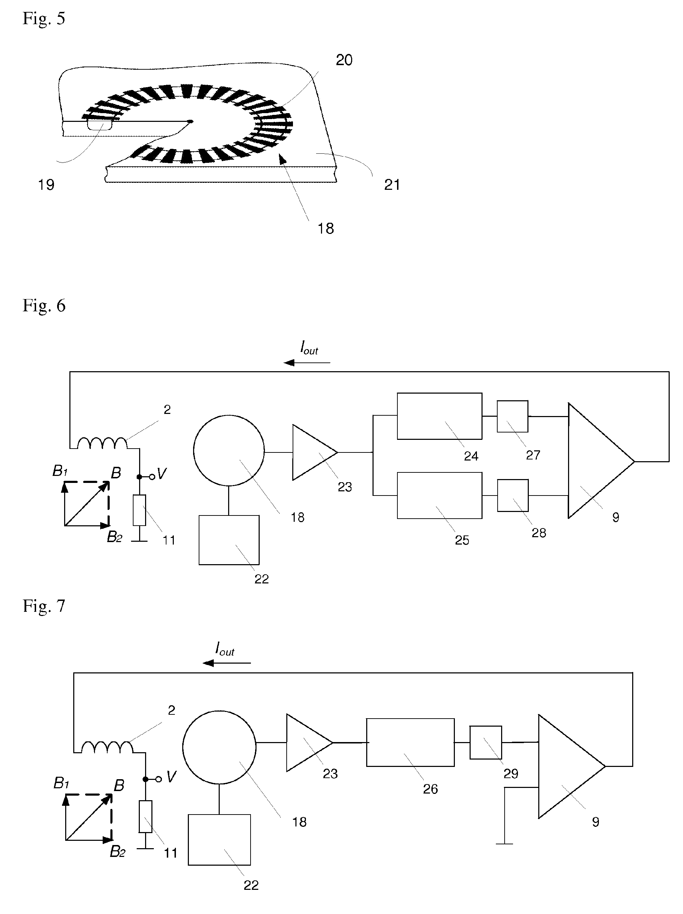

The two-axes magnetic field sensor 4 may be any magnetic field sensor that is driven by an input current and can therefore be operated in the above described manner in the open-loop or closed-loop mode. The magnetic field sensor may thus comprise for example Hall elements and/or magnetoresistive sensors. A sensor with a sensing structure 18 that may be operated either as a two-axes magnetic field sensor or a magnetic angle sensor is described in the European patent application no. 07109063.3 which is hereby incorporated by reference. Fig. 5 schematically illustrates the sensing structure 18 which comprises a ring-shaped, electrically conductive well 19 and a plurality of at least eight contacts 20 of equal size placed at equal distance from each other along the ring-shaped well 19 and contacting the ring-shaped well 19. The ring-shaped well 19 is of a first conductivity type and is embedded in an area, for example in a substrate 21, of a second conductivity type. The sensor further comprises circuitry for operating the sensing structure 18 as a vertical Hall element that moves in steps along the ring-shaped well 19. The circuitry includes a plurality of electronic switches associated with the contacts 20 of the sensing structure 18, wherein at least four electronic switches are associated with each of the contacts 20, a logic block for controlling the electronic switches, a timing circuit providing a control signal for controlling the logic block and providing a reference signal. The logic block is adapted to close and open the electronic switches under the control of the control signal according to a predetermined scheme such that a predetermined number of contacts of the plurality of contacts 20 form the vertical Hall element that is supplied with a constant current and that has two contacts connected to a voltage measuring means, and such that the vertical Hall element is moved in steps along the ring-shaped well. Finally, the current sensor comprises demodulating circuitry for either determining the angle the total magnetic field B includes with a predetermined axis or the magnitude of the primary and secondary magnetic field. This will be explained in more detail with reference to Figs. 6 and 7.

If a ring-shaped or disk like layer of ferromagnetic material of about equal size as the ring-shaped well 19 is applied concentrically with the ring-shaped well 19, then the ferromagnetic layer acts as a magnetic field concentrator and the sensing structure 18 forms a moving horizontal Hall element.

Figs. 6 and 7 are block diagrams of a current sensor having a sensing structure 18 as shown in Fig. 5 that is operated in the closed-loop mode either as two-axes magnetic field sensor as illustrated in Fig. 6 or as magnetic angle sensor as illustrated in Fig. 7. The current sensor's circuitry comprises circuitry 22 needed to operate the sensing structure 18 as a Hall element that moves in steps along the ring-shaped well 19 (Fig. 5). The output signal of the sensing structure 18 which is the Hall voltage of the moving Hall device is amplified by an amplifier 23 and fed to either two demodulators 24 and 25 according to Fig. 6 or one demodulator 26 according to Fig. 7. With both embodiments, the current sensor further comprises a comparator 9 having two inputs. The output of the comparator 9 is connected with an input of the coil 2. The output of the comparator 9 delivers an output current Iₒᵤₜ that is fed to the coil 2 and flows through the coil 2 and a resistor 11 arranged in series with the coil 2. The comparator 9 adjusts the output current Iₒᵤₜ such that the primary magnetic field B and the secondary magnetic field B₂ are equal in size. The voltage V at the node between the coil 2 and the resistor 11 - which corresponds to the voltage drop on the resistor 11 - is the output signal of the current sensor and is proportional to the primary magnetic field B and therefore proportional to the primary current. Let's assume that the circuitry 22 moves the Hall element such that it performs its turns with the frequency f and that the Hall voltage V_{H} is proportional to B*cos(2π*f*t - α) wherein the quantity t denotes the time and the quantity α denotes the angle which the total magnetic field B includes with the direction of the secondary magnetic field B₂.

Referring now to Fig. 6 the demodulator 24 multiplies the amplified Hall voltage V_{H} with the signal cos(2π*f*t) and the demodulator 25 multiplies the amplified Hall voltage V_{H} with the signal sin(2n*f*t). The output signal of the first demodulator 24 is proportional to the primary magnetic field B₂ and the output signal of the second demodulator 25 is proportional to the secondary magnetic field B₁. The demodulated signals are fed either directly or preferably after filtering with a low pass filter 27 or 28 to the two inputs of the comparator 9. Preferably, the two low pass filters 27 and 28 are designed also as amplifiers with different gains, wherein the gain of the low pass filter 28 is higher by a predetermined factor n than the gain of the low pass filter 27. The result is that the secondary magnetic field B₂ is regulated to a value that is by the factor n smaller than the primary magnetic field B₁.

Referring now to Fig. 7 the demodulator 26 multiplies the amplified Hall voltage V_{H} with the signal sin(2π*f*t - γ). The quantity γ is a predetermined angle, preferably γ = π /4. The demodulated signal is then fed either directly or after filtering with a low pass filter 29 to the first input of the comparator 9 while a constant voltage is applied to the second input of the comparator 9, which constant voltage is ground in this example. The embodiment according to Fig. 7 is simpler than the embodiment according to Fig. 6 because it contains only one demodulator but at the costs that the secondary magnetic field B₂ must be of equal size than the primary magnetic field B₁. The angle γ may be selectively chosen from a set of different values according to the needs of the current measurement. The comparator 9 adjusts the output current Iₒᵤₜ such that the total magnetic field B includes the angle with the direction of the secondary magnetic field produced by the output current Iₒᵤₜ flowing through the coil 2.

The circuitry of the current sensor comprise analog components but may also comprise digital components. The two-axes magnetic field sensor may be any sensor that is suitable for the above illustrated embodiments, e.g.
- a moving Hall element based on the sensing structure 18 described above,
- two Hall devices sensitive to two directions that include the angle ϕ,
- two magnetoresistive sensors sensitive to two directions that include the angle ϕ,
- a combination of Hall devices and magnetoresistive sensors wherein the magnetoresistive sensors cover a first working area of relatively low magnetic fields and the Hall devices cover a second working area of relatively big magnetic fields.

While embodiments and applications of this invention have been shown and described, it would be apparent to those skilled in the art having the benefit of this disclosure that many more modifications than mentioned above are possible without departing from the inventive concepts herein. The invention, therefore, is not to be restricted except by the appended claims and their equivalents.

## Claims

1. Current sensor for measuring a primary current flowing through a conductor, comprising a magnetic field sensor, a coil (2) and electronic circuitry for making a secondary current flow through the coil (2), wherein the primary current produces a primary magnetic field and the secondary current produces a secondary magnetic field which add up to a total magnetic field, **characterized either in that** the magnetic field sensor is a two-axes magnetic field sensor (4) providing a first output signal that is proportional to a first component of the total magnetic field and a second output signal that is proportional to a second component of the total magnetic field wherein the first and second component of the total magnetic field point in different directions and wherein the coil (2) and the two-axes magnetic field sensor (4) are oriented with respect to each other such that the second output signal is proportional to the secondary magnetic field, or in that the magnetic field sensor is an angle sensor (12) providing an output signal proportional to an angle which the total magnetic field includes with a predetermined direction.

2. Current sensor according to claim 1, wherein the magnetic field sensor is the named two-axes magnetic field sensor (4), **characterized by**
a constant current source (3) arranged in series with the coil (2) and producing the secondary current,
a second current source (5) delivering a constant biasing current I_{bias}, and
a feedback circuitry (6) comprising a first pre-amplifier (7) for the amplification of the first output signal, a second pre-amplifier (8) for the amplification of the second output signal and a feedback loop comprising a comparator (9) having a first input, a second input and an output delivering an output current, wherein the second output signal of the two-axes magnetic field sensor (4) is fed to the first pre-amplifier (7), the output signal of the second pre-amplifier (8) is fed to the first input of the comparator (9), a constant voltage is fed to the second input of the comparator (9), the output current of the comparator (9) and the biasing current delivered by the second current source (5) are fed to a summing junction (10) and wherein the output current of the summing junction (10) is fed to the two-axes magnetic field sensor (4).

3. Current sensor according to claim 1, wherein the magnetic field sensor is the named two-axes magnetic field sensor (4), **characterized by** a comparator (9) having a first input, a second input and an output delivering an output current, a first amplifier (13) for the amplification of the first output signal wherein an output of the first amplifier (13) is connected with the first input of the comparator (9), a second amplifier (14) for the amplification of the second output signal wherein an output of the second amplifier (14) is connected with the second input of the comparator (9), and a resistor (11) arranged in series with the coil (2), wherein the output of the comparator (9) is connected with an input of the coil (2).

4. Current sensor according to claim 3, **characterized in that** a gain of the first amplifier (13) is smaller by a predetermined factor than a gain of the second amplifier (14).

5. Current sensor according to claim 1, wherein the magnetic field sensor is the named two-axes magnetic field sensor, **characterized by** a comparator (9) having a first input, a second input and an output delivering an output current, and a resistor (11) arranged in series with the coil (2), the two-axes magnetic field sensor comprising
a sensing structure (18) comprising a ring-shaped well (19) of a first conductivity type embedded in an area of a second conductivity type, and a plurality of contacts (20) of equal size placed at equal distance from each other along the ring-shaped well (19) and contacting the ring-shaped well (19),
circuitry (22) for operating the sensing structure (18) as a Hall element that moves in steps along the ring-shaped well (19),
a first demodulator (24) for demodulating an output signal of the sensing structure (18) in order to get the first output signal,
a second demodulator (25) for demodulating the output signal of the sensing structure (18) in order to get the second output signal,
wherein the first output signal is fed to the first input of the comparator (9), the second output signal is fed to the second input of the comparator (9) and the output of the comparator (9) is connected with an input of the coil (2).

6. Current sensor according to claim 5, **characterized in that** a first low pass filter (27) is placed between the output of the first demodulator (24) and the first input of the comparator (9), a second low pass filter (28) is placed between the output of the second demodulator (25) and the second input of the comparator (9), wherein the first and second low pass filter also act as amplifiers wherein a gain of the second low pass filter (28) is higher by a predetermined factor than a gain of the first low pass filter (27).

7. Current sensor according to claim 1, wherein the magnetic field sensor is the named angle sensor (12), **characterized by** a comparator (9) having a first input, a second input and an output delivering an output current, and a resistor (11) arranged in series with the coil (2), wherein the output signal of the angle sensor (12) is fed to the first input of the comparator (9) and a constant reference voltage is applied to the second input of the comparator (9), and wherein the output of the comparator (9) is connected with an input of the coil (2).

8. Current sensor according to claim 1, wherein the magnetic field sensor is the named angle sensor (12), **characterized by** a comparator (9) having a first input, a second input and an output delivering an output current, and a resistor (11) arranged in series with the coil (2), the angle sensor (12) comprising
a sensing structure (18) comprising a ring-shaped well (19) of a first conductivity type embedded in an area of a second conductivity type and a plurality of contacts (20) of equal size placed at equal distance from each other along the ring-shaped well (19) and contacting the ring-shaped well (19),
circuitry (22) for operating the sensing structure (18) as a Hall element that moves in steps along the ring-shaped well (19),
a demodulator (26) for demodulating an output signal of the sensing structure (18) in order to get the output signal,
wherein the output signal is fed to the first input of the comparator (9), a constant voltage is applied to the second input of the comparator (9) and the output of the comparator (9) is connected with an input of the coil (2).

9. Assembly group for current measurement, comprising a conductor (15) and a current sensor according to any of claims 1 to 8, wherein the current in the current conductor (20) flows in a predetermined direction, **characterized in that** the direction of the windings of the coil (2) that produce the secondary magnetic field include an angle ϕ with the predetermined direction that is different from zero.

10. Assembly group for current measurement according to claim 9, **characterized in that** the angle ϕ approximately amounts to ϕ = 90°.
